(19) Europäisches Patentamt
European Patent Office
Office européen des brevets

(11) **EP 2 249 394 A1**

(12) **EUROPEAN PATENT APPLICATION**
published in accordance with Art. 153(4) EPC

(43) Date of publication:
**10.11.2010 Bulletin 2010/45**

(21) Application number: **09714008.1**

(22) Date of filing: **23.02.2009**

(51) Int Cl.:
**H01L 31/04** *(2006.01)*        **H01L 31/042** *(2006.01)*

(86) International application number:
**PCT/JP2009/053197**

(87) International publication number:
**WO 2009/107584 (03.09.2009 Gazette 2009/36)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **25.02.2008 JP 2008043601**

(71) Applicant: **Sharp Kabushiki Kaisha**
**Osaka-shi, Osaka 545-8522 (JP)**

(72) Inventors:
• **HASEGAWA, Masatomo**
  **Osaka 545-8522 (JP)**
• **SHIMIZU, Akira**
  **Osaka 545-8522 (JP)**

(74) Representative: **Müller - Hoffmann & Partner**
**Patentanwälte**
**Innere Wiener Strasse 17**
**81667 München (DE)**

(54) **PHOTOVOLTAIC POWER SYSTEM**

(57)     A system of high efficiency and low cost is provided as a photovoltaic power system comprising a solar cell connected to a power converter.

A photovoltaic power system comprising a plurality of solar cell modules connected in parallel to a power converter, the solar cell modules outputting a voltage higher than an output voltage of the power converter.

FIG. 1

$$Vdc > \alpha \times Vac$$
$$VM(n) > Vdc$$
$$A > \sqrt{(2)} + \beta$$

VM(n): Module output voltage
Vdc: DC input voltage
Vac: AC output voltage
    (effective value)

**Description**

TECHNICAL FIELD

The present invention relates to a photovoltaic power system comprising a solar cell module connected to a power converter.

BACKGROUND ART

Wafer-shaped crystalline silicon solar cells have a low output voltage per cell and, even in a form of a module consisting of a plurality of solar cells connected in series, the output voltage thereof is generally lower than a voltage supplied to electronic devices or electric devices.

It is well known that a plurality of solar cell modules are therefore connected in series to increase the output voltage and connected to a power converter at a desirably set output voltage. For example, Patent Document 1 shows an example where a power generation block having a cell array in which four solar cell modules are connected in series is installed on a house roof, and main cables from the power generation block are gathered in a connection box to be connected in parallel, which is connected to an input side of a DC/AC converter. In the case of Patent Document 1, the voltage generated per cell module is 50 V and four cell modules are connected in series. Therefore, the output voltage of the power generation block comes to 200 V.

[Patent Document 1] Japanese Unexamined Patent Publication No. 2002-1246694

DISCLOSURE OF THE INVENTION

PROBLEMS TO BE SOLVED BY THE INVENTION

As described above, the installing area of a solar cell system to be installed on a house roof or the like varies, and so the number of modules that can be connected in series is limited. Also, the orientation and the angle of a roof surface vary, and so the output voltage of a solar cell array varies every system.

In order to absorb such a difference in output voltages depending on the system, the input voltage of general DC/AC converters is designed to have an input range (for example, 80 V to 380 V) specific to a device, and the number of solar cell modules in series is set so that the solar cell array falls within this range. In DC/AC converters, power is inputted with various voltages and the voltages are boosted to a certain voltage (for example, 400 V) by means of a booster circuit to perform DC/AC conversion.

However, power converting circuits that require a booster circuit had a problem in that the conversion efficiency decreases. In addition, in the case of a photovoltaic power system having a plurality of solar cell arrays, it was necessary to provide a booster circuit to each solar cell array and perform power conversion after absorbing a difference in the output voltages depending on the solar cell array, making the system complicated and causing increase of costs.

In view of such problems, an object of the present invention is to provide a system of high efficiency and low cost as a photovoltaic power system comprising a solar cell connected to a power converter.

MEANS FOR SOLVING THE PROBLEMS

In order to solve the above-described problems, the photovoltaic power system of the present invention is a photovoltaic power system comprising a plurality of solar cell modules connected in parallel to a power converter, the solar cell modules outputting a voltage higher than an output voltage of the power converter.

EFFECTS OF THE INVENTION

According to the photovoltaic power system of the present invention, the power converter performs power conversion without boosting the output voltage of the solar cell modules, whereby the configuration of the power converter is simpler, the conversion efficiency increases, and a system of low cost can be provided.

BRIEF DESCRIPTION OF THE DRAWINGS

FIG. 1 is a block diagram of Embodiment 1 of the present invention.
FIG. 2 is a plan view and a sectional view of a thin-film solar cell module 1.

FIG. 3 is a circuit diagram of the thin-film solar cell module 1.

FIG. 4 is an explanatory diagram of a measurement circuit of a short-circuit resistance Rsh.

FIG. 5 is an explanatory diagram of a method for measuring the short-circuit resistance Rsh.

FIG. 6 is a diagram showing the relationship between the short-circuit resistances Rsh and Prsh when the short-circuit resistance Rsh varies.

FIG. 7 is a diagram illustrating distribution of the short-circuit resistance Rsh of a thin-film solar cell module.

FIG. 8 is a plan view and a sectional view of a thin-film solar cell module 2.

FIG. 9 is a circuit diagram of the thin-film solar cell module 2.

FIG. 10 is a plan view and a sectional view of a thin-film solar cell module 3.

FIG. 11 is a circuit diagram of the thin-film solar cell module 3.

FIG. 12 is a block diagram of Embodiment 2 of the present invention.

FIG. 13 is a block diagram of Embodiment 3 of the present invention.

FIG. 14 is a block diagram of Embodiment 4 of the present invention.

DESCRIPTION OF THE REFERENCE NUMERALS

| | |
|---|---|
| M1, M2, M3, M4 | Thin-film solar cell modules |
| DA | DC/AC converter |
| BD | Protective member |
| R1, R2, R3, R4 | Resistances |
| VM1, VM2, VM3, VM4 | Output voltages of thin-film solar cell modules |

BEST MODE FOR CARRYING OUT THE INVENTION

The photovoltaic power system of the present invention is a photovoltaic power system comprising a plurality of solar cell modules connected in parallel to a power converter, the solar cell modules outputting a voltage higher than an output voltage of the power converter. In an embodiment, the present invention is **characterized in that** the output voltages of the solar cell modules are $\sqrt{2}$ to 10 times the output voltage of the power converter.

With this characteristic, the power converter can perform power conversion without boosting the output voltages of the solar cell modules and, as a result, can supply power to systems having an electronic device or an electric device connected thereto. In particular, the number of times 2 to 5 results in higher efficiency.

In an embodiment, the photovoltaic power system of the present invention is **characterized in that** all the solar cell modules are connected in parallel.

In an embodiment, the photovoltaic power system of the present invention is **characterized in that** it links with an AC commercial power system.

With the characteristics, a photovoltaic power system can be provided, which is stable and, even in a system-interconnection system of residence use or the like for which installation conditions vary, free from influence of such variety.

In an embodiment, the photovoltaic power system of the present invention is **characterized in that** the solar cell modules are thin-film solar cell modules comprising a thin-film solar cell string comprising a plurality of thin-film solar cell elements interconnected in series in which a surface electrode, a photoelectric conversion layer, and a back surface electrode are laminated in this order.

The thin-film solar cell elements are solar cell elements produced by using thin-film techniques, such as silicon thin-film solar cell modules including amorphous silicon, microcrystalline silicon, polycrystalline thin-film silicon, and the like; and compounds thin-film solar cell modules including $Cu(InGa)Se_2$, CdTe, $CuInSe_2$ and the like. And the thin-film solar cell elements output a voltage higher than that from crystal type solar cells, amorphous solar cell elements, and polycrystalline solar cells, and use an integration technique to increase the number of series connection stages, thereby enabling output of a higher voltage than a voltage to be supplied to an electronic device and an electric device. For example, it is possible to output a high voltage of approximately several 100 V to 1000 V. Therefore, the system of the present invention can be used with a relatively high voltage.

In an embodiment, the photovoltaic power system of the present invention is **characterized in that** a protective member is inserted in a connection line, respectively, by which the thin-film solar cell modules are connected to the power converter in parallel.

With this characteristic, each thin-film solar cell module is protected from the other thin-film solar cell modules and is not affected by power output of the other thin-film solar cell modules.

In an embodiment, the photovoltaic power system of the present invention is **characterized in that** the protective member is a blocking diode or a fuse.
With this characteristic, it is possible to protect each thin-film solar cell module.

In an embodiment, the photovoltaic power system of the present invention is **characterized in that** a resistance is connected in a line, respectively, by which the plurality of thin-film solar cell modules are connected in parallel.
With this characteristic, it is possible to make the output voltage of each thin-film solar cell module equal to the input voltage of the power converter.

In an embodiment, the photovoltaic power system of the present invention is **characterized in that** the closer the resistance is to the power converter, the smaller the value of the resistance is.
With this characteristic, it is possible to make the output voltage of each thin-film solar cell module equal to the input voltage of the power converter.

In an embodiment, the photovoltaic power system of the present invention is **characterized in that** the resistances are formed of a connection line connecting the plurality of thin-film solar cell modules to the power converter in parallel.
With this characteristic, it is possible to use the resistance of the connection line to make the output voltage of each thin-film solar cell module equal to the input voltage of the power converter.

In an embodiment, the photovoltaic power system of the present invention is **characterized in that** the closer the plurality of thin-film solar cell modules are to the power converter, the lower the output voltage thereof is.
With this characteristic, it is possible to take out the output power of each thin-film solar cell module effectively.

In an embodiment, the photovoltaic power system of the present invention is **characterized in that** the thin-film solar cell string has the number of series connection stages of the thin-film solar cell elements that satisfies the following formula (1):

$$n < Rshm \; / \; 2.5 \; / \; Vpm \; \times \; Ipm + 1 \quad (1),$$

wherein Rshm is the most frequent short-circuit resistance value of the thin-film solar cell elements;
Vpm is an optimum operation voltage of the thin-film solar cell elements; and
Ipm is an optimum operation current of the thin-film solar cell elements.
With this characteristic, it is possible to increase hot spot resistance and increase the output voltage.

In an embodiment, the photovoltaic power system of the present invention is **characterized in that** the optimum operation voltage of the thin-film solar cell string is more than 150 V.
With this characteristic, it is possible to set the number of series connection stages of the thin-film solar cell elements appropriately.

Embodiment 1

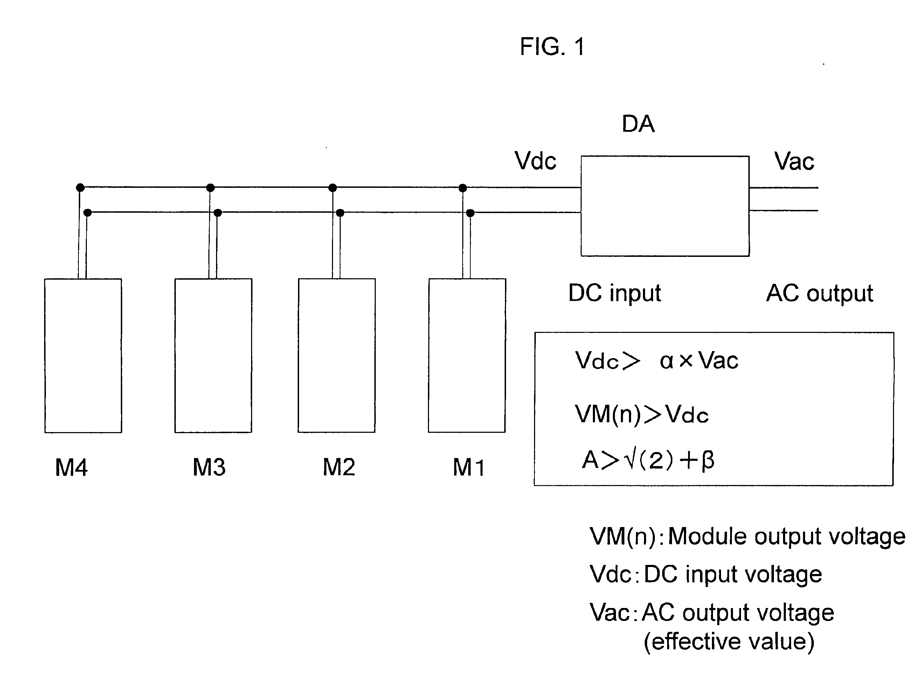

FIG. 1 illustrates a block diagram of Embodiment 1 of the present invention. As illustrated in FIG. 1, there are four solar cell modules M, and the four solar cell modules M are connected together in parallel and connected to a DC input terminal of a DC/AC converter DA. Here, each solar cell module M is formed of thin-film solar cell elements, and an output voltage of each solar cell module M is higher than an AC output voltage (effective value) of the DC/AC converter DA. Furthermore, the output voltage VM of each solar cell module M is set to be higher than an input voltage of the DC/AC converter DA. While FIG. 1 illustrates a photovoltaic power system in which four solar cell modules are connected in parallel, the number of the solar cell modules is not limited and it is possible to connect any number of solar cell modules that are necessary for large scale power generation.

An output voltage Vdc of each solar cell module M is set to be approximately $\sqrt{2}$ times to several 10 times the AC output voltage (effective value) of the DC/AC converter DA. Therefore, the output voltage Vdc of the solar cell modules M is 140 V to 1000 V, when the AC output voltage is 100 V. And, the output voltage Vdc of the solar cell modules M is 300 V to 2200 V, when the AC output voltage is 220 V. In particular, the number of times approximately 2 to 5 results in higher conversion efficiency of the DC/AC converter DA. With this configuration, an alternating current high voltage output photovoltaic power system can be achieved. In addition, according to the present invention, direct input to the DC/AC converter is possible. Furthermore, since any number of solar cell modules can be connected in parallel, the present invention can be applied from small scale power generating systems to large scale power generating systems.
Moreover, it is ideal that all the output voltages of the solar cell modules are equal, and in that case, it is possible to take out the maximum power; however, in the present invention, the solar cell modules are connected in parallel, and therefore it is possible to take out power effectively even if all the solar cell modules do not output an equal output voltage.

Therefore, installation directions, installation conditions, solar radiation receiving conditions, and the like of the solar cell modules do not need to be completely equal, facilitating installation design and construction. In addition, even when some solar cell modules are in shade to output a decreased voltage, the output voltage of the solar cell modules not in shade is not decreased.

These characteristics are particularly effective in photovoltaic power systems for residence use or the like for which installation conditions are various.

The above-described solar cell modules M comprise a thin-film solar cell string comprising a plurality of thin-film solar cell elements interconnected in series, each of the thin-film solar cell elements including a surface electrode, a photoelectric conversion layer, and a back surface electrode laminated in this order. And, as shown above, the photovoltaic power system requiring a high voltage as much as several hundreds V and the photovoltaic power system for residence use or the like that links with commercial power can be achieved by using a thin-film solar cell that is configured as follows.

<Thin-film solar cell string 1>

## - Example of 53 stages $\times$ 12 parallels $\times$ 2 blocks in series -

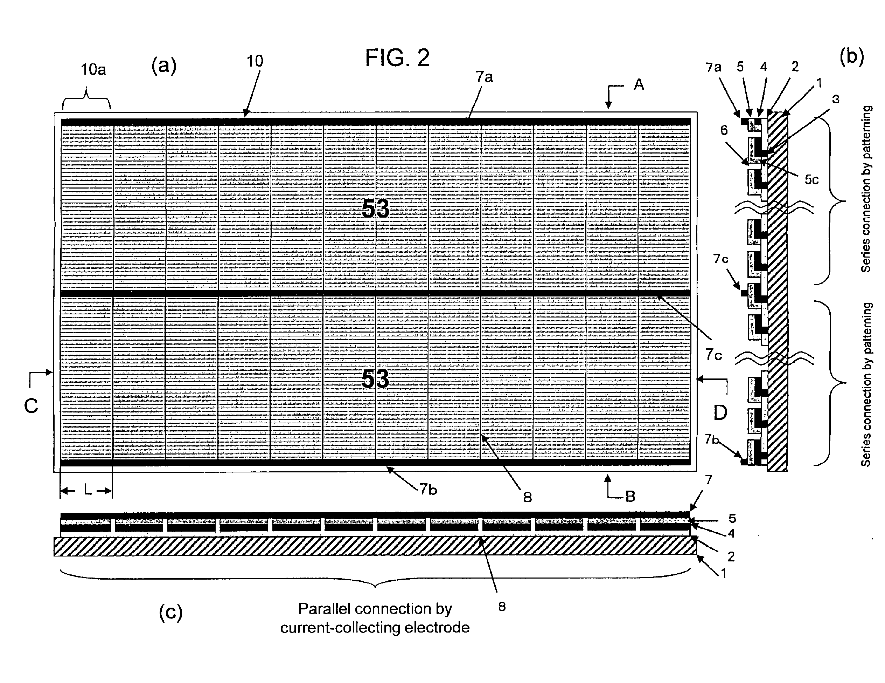

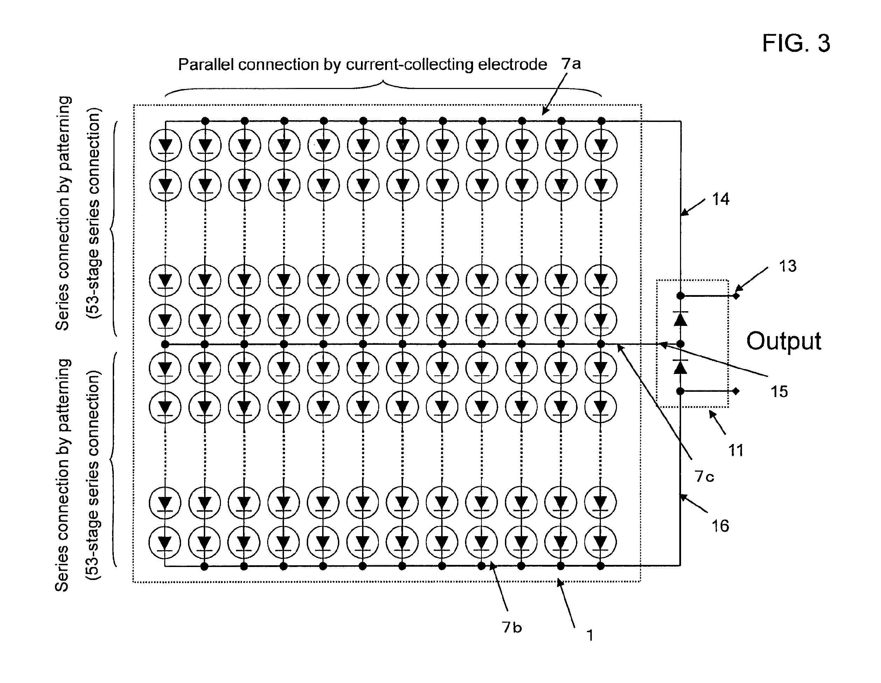

FIG. 2 illustrates an integrated thin-film solar cell module associated with the thin-film solar cell string 1, and FIG. 2 (a) is a plan view, FIG. 2 (b) is a cross-sectional view taken along lines A-B of FIG. 2 (a), and FIG. 2 (c) is a cross-sectional view taken along lines C-D of FIG. 2 (a). FIG. 3 illustrates a circuit diagram.

In the thin-film solar cell string 1, a supporting substrate 1 is, for example, a translucent glass substrate or a resin substrate such as a polyimide or the like. On the substrate (surface), a first electrode (for example, a transparent conductive film of $SnO_2$ (tin oxide)) is formed by a thermal CVD method or the like. As long as the first electrode is a transparent electrode, it may be, for example, ITO which is a mixture of $SnO_2$ and $In_2O_3$. Thereafter, the transparent conductive film is appropriately removed by patterning to form dividing scribe lines 3. Formation of the dividing scribe lines 3 forms the first electrode 2 that is divided into several pieces. The dividing scribe lines 3 are formed by cutting the first electrode by a groove-like shape (scribe line shape) by means of a laser scribing beam, for example.

Next, on the first electrode 2, a photoelectric conversion layer 4 is formed by forming a film of semiconductor layers (for example, amorphous silicon or microcrystalline silicon) of, for example, p-type, i-type, and n-type in sequence by a CVD method. At the same time, the dividing scribe lines 3 are also filled with the photoelectric conversion layer. The photoelectric conversion layer 4 may be of a p-n junction or a p-i-n junction. In addition, the photoelectric conversion layer 4 may be laminated into one, two, three, or more stages, and sensitivity of each solar cell element may be made to sequentially shift to a longer wavelength as it is distant from the substrate side. When the photoelectric conversion layer is laminated into a plurality of layers as described above, the layers may include a layer such as a contact layer, an intermediate reflection layer or the like therebetween.

When the photoelectric conversion layer 4 is laminated into a plurality of layers, all the semiconductor layers may be an amorphous semiconductor or a microcrystalline semiconductor, or may be any combination of an amorphous semiconductor and a microcrystalline semiconductor. That is, the structure may be a laminate in which the first photoelectric conversion layer is of an amorphous semiconductor and the second and third photoelectric conversion layers are of a microcrystalline semiconductor; a laminate in which the first and second photoelectric conversion layers are of an amorphous semiconductor and the third photoelectric conversion layer is of a microcrystalline semiconductor; or a laminate in which the first photoelectric conversion layer is of a microcrystalline semiconductor and the second and third photoelectric conversion layers are of an amorphous semiconductor.

In addition, while the above-described photoelectric conversion layer 4 is of a p-n junction or a p-i-n junction, it may be of an n-p junction or an n-i-p junction. Furthermore, the p-type semiconductor layer and the i-type semiconductor layer may or may not have a buffer layer of an i-type amorphous material therebetween. Usually, in the p-type semiconductor layer, a p-type impurity atom such as boron, aluminum or the like is doped, and in the n-type semiconductor layer, an n-type impurity atom such as phosphorus or the like is doped. The i-type semiconductor layer may be completely undoped or may be of a weak p-type or a weak n-type including a small amount of impurity.

The photoelectric conversion layer 4 is not limited to silicon, and may be formed of a silicon semiconductor such as silicon carbide containing carbon or silicon germanium containing germanium, or a compound semiconductor of a compound such as $Cu(InGa)Se_2$, CdTe, and $CuInSe_2$.

Here, the photoelectric conversion layer 4 of the thin-film solar cell string 1 is of a p-i-n junction, constituting a three-junction type thin-film solar cell of a laminate of three cells of amorphous silicon/amorphous silicon/microcrystalline silicon.

Then, connection grooves are formed on the photoelectric conversion layer 4 by laser scribing or the like, and a second electrode (ZnO/Ag electrode or the like) is formed thereon by sputtering or the like. As a result, the connection grooves are filled with the second electrode material, and contact lines 5c are formed. As a result, the second electrode 5 divided on the photoelectric conversion layer 4 and the adjacent first electrode 2 on the photoelectric conversion layer 4 will be connected via the contact lines 5c, and a plurality of thin-film solar cell elements will be connected in series. Furthermore, cell dividing grooves 6 are formed in parallel with the contact lines 5c by laser scribing or the like to divide the thin-film solar cell elements to a plurality of pieces. Thereby, in an example of FIG. 3, each individual solar cell element (cell) is divided to be in an equal size, and a thin-film solar cell string 10 (hereinafter, may be referred to as cell string) is formed, having a plurality of solar cell elements connected in series in the vertical direction of FIG. 3. At this time, the dividing scribe lines 3, the contact lines 5c, and the cell dividing grooves 6 are formed so that the number of stages n of the series connection of the thin-film solar cell elements comes to an integral multiple of the following formula (1). That is, the number of stages n of the series connection of the thin-film solar cell elements in the cell string is determined to satisfy the following formula (1):

$$n < Rshm \; / \; 2.5 \; / \; Vpm \; \times \; Ipm + 1 \quad (1),$$

wherein Rshm is the most frequent short-circuit resistance value of the thin-film solar cell elements;
Vpm is an optimum operation voltage of the thin-film solar cell elements; and
Ipm is an optimum operation current of the thin-film solar cell elements.
In the thin-film solar cell module of the above-described configuration, the output of the thin-film solar cell string will be short-circuited by a bypass diode, when the thin-film solar cell string comprising n stages of solar cell elements integrated is in a hotspot state due to one stage of thin-film solar cell elements of those being in shade. An equivalent circuit in this case is in a state where the (n-1) stages of thin-film solar cell elements in light have the one stage of thin-film solar cell elements not in light connected thereto as a load. Therefore, most power generated in the region being in light in the thin-film solar cell string will be consumed in the thin-film solar cell elements in shade, without being taken out of the thin-film solar cell string. Then, when the reverse breakdown voltage is sufficiently high in the normal region of the thin-film solar cell elements in shade, the current that flows to the thin-film solar cell elements goes to a region within the surface short-circuited by dust, flaws, and protrusions, and a region of low resistance around the laser scribing and the like.
To give a measure of how easy the current flows, where the short-circuit resistance to be worked out from current-voltage characteristics when a backward voltage of approximately 0 to several V is applied to the thin-film solar cell elements is Rsh [Ω], the power is most concentrated on the short-circuit part when the short-circuit resistance Rsh is equal to an optimum load Rshpm with respect to the (n-1) stages of cells in light. Therefore, the module needs to be designed so that the short-circuit resistance Rsh is prevented from being close to the value.
Here, a measuring method of the short-circuit resistance Rsh will be described.
The short-circuit resistance Rsh of the solar cell module can be measured according to the following steps:

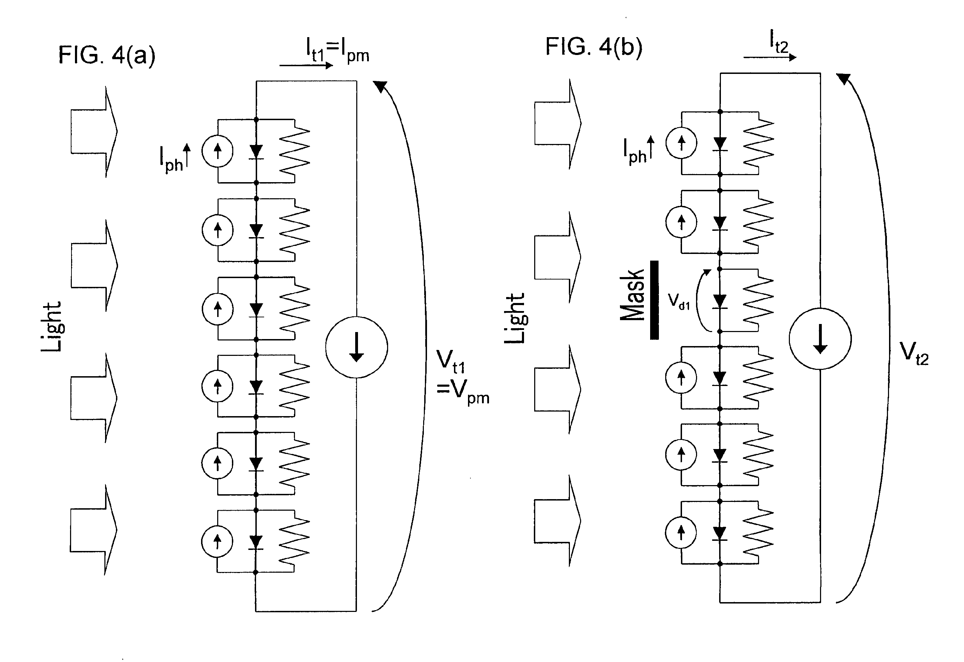

(1) In the case of a module having a blocking diode built therein, the blocking diode is removed.
(2) In the case of a module having a bypass diode(s) built therein, all the bypass diode(s) is removed.
(3) In the case of a module in which a plurality of bypass diodes are used, the module is processed so that output can be taken out in a unit in which the bypass diodes were connected. In the following test, evaluation is performed by the unit in which the bypass diodes were connected. In the case of one or no bypass diode, the evaluation is performed by the module.
(4) When the evaluation object includes a plurality of cell strings having a plurality of cells connected in series, and they have a configuration of parallel connection, all the strings other than one string to be evaluated are covered so as not to be in light, or the parallel connection is disconnected so that only one string to be evaluated can be evaluated in the following evaluation.
(5) The evaluation object is put in light of 1000 W/m$^2$ (or 1000 ± 200 W/m$^2$) with the use of a fixed light solar simulator or outdoor light and held until temperature becomes stable.
(6) An I-V curve is measured under a condition of stable temperature and illuminance. Thereby, Vpm and Ipm are determined. The output current for each solar cell is Iph.
(7) A current of It1 = Ipm is applied from outside with the use of a constant-current source while keeping the module in the fixed light. At this time, an output voltage Vt1 of the evaluation object is Vpm. (see FIG. 4(a))
(8) One stage of cells are masked and measured for an output voltage Vt2 then. The output voltage of the masked cells is Vd1. (see FIG. 4(b))
Since heat may be generated to break the cells if the reverse breakdown voltage of the cells is high here, Vt2 is given an appropriate limit so as not to be Vt2 < 0. When the limit is reached, It2 at the time of Vt2 = 0 is recorded, and a voltage at the time when the current is It2 is obtained from the I-V curve measured in (6) to determine Vt1.

(9) When the number of series connection stages in the cell string is n,

$$Vd1 = Vt2 - (n-1) / n \times Vt1,$$

and

$$Rsh = -Vd1 / It2,$$

whereby Rsh of the masked cells is determined.

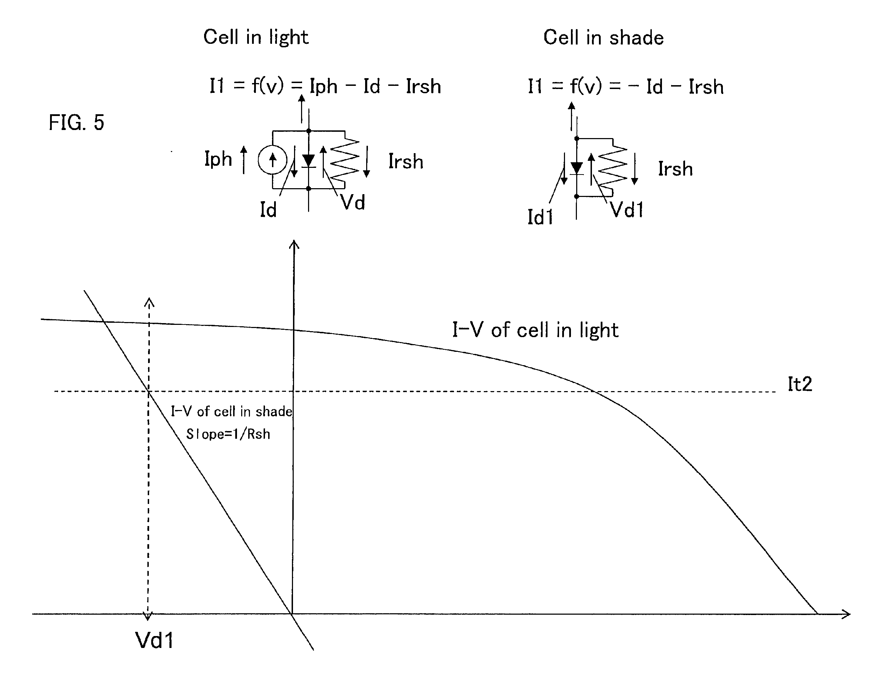

(10) The evaluation described in (8) and (9) is repeated for all cells to measure Rsh of each cell. FIG. 5 illustrates a current I1 and an I-V property of a cell in light. FIG. 5 also illustrates a current I1 and an I-V property, that is, a slope 1/Rsh of a cell in shade.

Thus, it is very likely that the short-circuit resistance Rsh damages the solar cell module, because the voltage-current is measured after the solar cell module is completed, the blocking diode and the bypass diode are removed from the completed solar cell module, and at least one stage of cells is put in shade.

As described above, therefore, may be adopted a method for measuring the short-circuit resistance Rsh by applying a reverse bias to the solar cell elements constituting the solar cell module and, by a leakage current that flows at the time, assuming: short-circuit resistance Rsh $\cong$ reverse bias voltage / leakage current. It is desirable that a voltage considered possible in a hotspot is applied as the reverse bias voltage being applied then. When the reverse breakdown voltage of each cell is high or unknown, however, it is desirable that the test is carried out with a voltage lower than a voltage considered possible in an actual hotspot. In the case of a tandem cell of an amorphous silicon and a micro crystallite, it is desirable to carry out the test with a backward voltage of 5 to 8 V.

For example, an optimum load Rshpm is reached as in the following formula (2), which is the worst, where an optimum operation voltage is Vpm [V], an optimum operation current is Ipm [A], and one stage of thin-film solar cell elements are in shade, as described above.

$$Rshpm = Vpm / Ipm \times (n-1) \qquad (2)$$

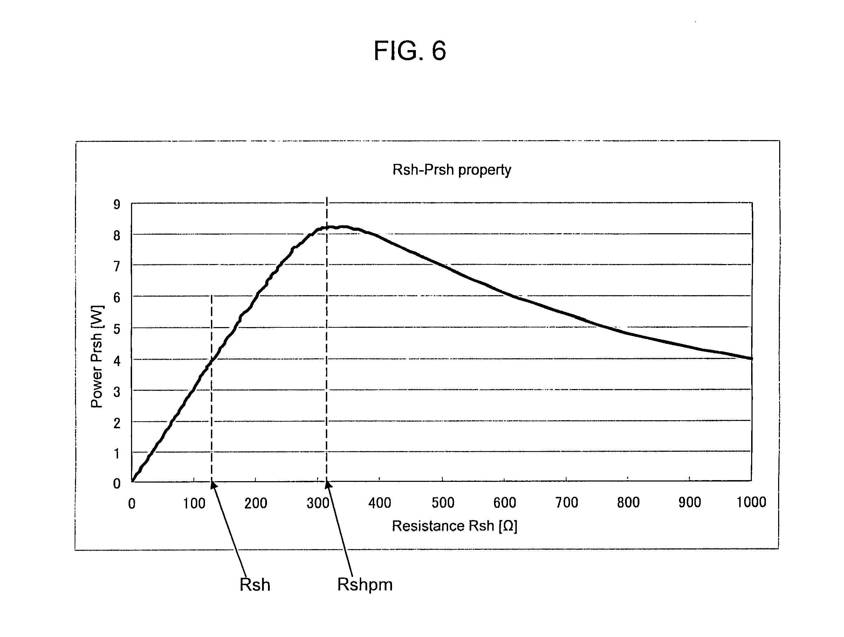

An actual short-circuit resistance Rsh is caused by various causes such as a region within the surface short-circuited by dust, flaws and protrusions, and a region of low resistance around the laser scribing. Rsh varies due to various reasons in a production step, distributed within a certain range. FIG. 6 illustrates the relationship between the short-circuit resistance Rsh and power Prsh consumed there, when the short-circuit resistance Rsh varies due to I-V properties of a representative silicon thin-film solar cell. When the above-described short-circuit resistance Rsh is approximately 2.5 times the optimum load Rshpm, deviating from the optimum load Rshpm, the power Prsh decreases to half or less. That is, In FIG. 6, the power is approximately 8 W when the optimum load Rshpm is approximately 330 Ω, and the power is approximately 4 W when the short-circuit resistance Rsh is 130 Ω. Therefore, it is possible to considerably reduce occurrence of peel-off due to a hotspot, if production can be carried out with the short-circuit resistance Rsh deviated from the optimum load Rshpm by 2.5 times or more. No matter how much the short-circuit load Rsh deviates from the optimum load Rshpm, it is acceptable as long as the deviation is by 2.5 times or more, because the deviation needs only to be by 2.5 times or more.

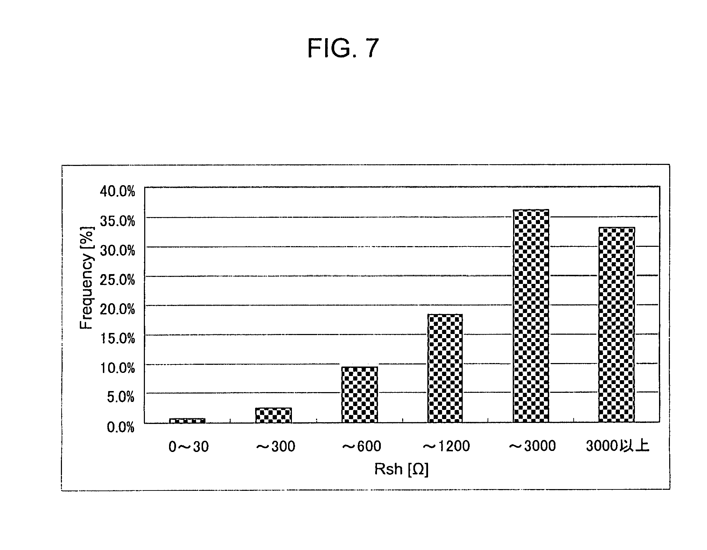

FIG. 7 illustrates distribution of the short-circuit resistance Rsh of a module actually produced. Factors that impair (= lower) the short-circuit resistance Rsh of the thin-film solar cell elements may include various events such as insufficient division at the dividing scribe lines; short circuit due to dust, protrusions, and pin holes within the surface; increase of reverse leakage current due to variation of production conditions; and lowered resistance of a doped layer. As a main factor around the peak of the distribution of short-circuit resistance Rsh (around 3000 Ω), however, leakage current at the dividing scribe lines mainly causes the lowering of the short-circuit resistance Rsh. In a range of the distribution of the short-circuit resistance Rsh lower than the vicinity of the peak, leakage current within the surface mainly causes the lowering of the short-circuit resistance Rsh.

When the factor of the leakage current is a short circuit within the surface, and a hotspot phenomenon occurs, the short-circuit region within the surface is peeled off or burnt off to cause high resistance, improving F.F. of the cell and offsetting lowering of Isc due to the peel-off. As a result, it is unlikely that the properties deteriorate significantly. However, when the factor of the leakage current is leakage current at the dividing scribe lines, and a hotspot phenomenon occurs, peel-off is generated from the dividing scribe lines, and solar cell elements in a normal region are involved to promote the peel-off or affect contact lines nearby. As a result, the properties and reliability deteriorate significantly compared to the case of the short circuit within the surface.

It is therefore desirable that the above-mentioned optimum load Rshpm comes outside a range where the main factor is leakage current at the dividing scribe lines and stays within a range where the main factor is leakage current within the surface. Specifically, when the most frequent short-circuit resistance value Rsh is Rshm, the optimum load Rshpm needs to be within a range of sufficiently low level with respect to Rshm. Since the short-circuit resistance Prsh for the most frequent value Rshm is approximately half of the short-circuit resistance Prsh for the optimum load Rshpm when the most frequent value Rshm is 2.5 times the optimum load Rshpm, parameters need to be selected so that the following formula (3) is satisfied:

$$\text{Rshm} > 2.5 \times \text{Rshpm} = 2.5 \times \text{Vpm} \div \text{Ipm} \times (n\text{-}1) \qquad (3)$$

Once type, structure, and production conditions of the solar cell elements constituting the thin-film solar cell module are determined, Vpm, Ipm, and Rshm are almost determined, and then the following formula (1) is obtained by modifying the formula (3), whereby the maximum number of integration stages that can keep hotspot resistance is determined.

$$n < \text{Rshm} \div 2.5 \div \text{Vpm} \times \text{Ipm} + 1 \qquad (1)$$

Practically, Rshm > approximately 2000 Ω and Vpm / Ipm = approximately 5 to 10 Ω in reasonable solar cell elements, because too low short-circuit resistance Rsh affects solar cell element properties, though it depends on the form of the solar cell elements. Here, n < 80 to 160. In the case of solar cell elements for which the optimum operation voltage Vpm = approximately 1.0 V, any thin-film solar cell modules having an optimum operation voltage of approximately 80 to 160 V will naturally fall within the range.

We have found that the matter becomes significant only when the optimum operation voltage of the module is more than approximately 160 V and, as a measure for this case, the number of integration stages needs to be determined so as to meet the formula (1).

In addition, when the maximum number of integration stages is limited in this way and it is desired to obtain a voltage output higher than a voltage output that can be achieved with the number of integration stages as the thin-film solar cell module, the inside of the thin-film solar cell module is divided to a plurality of blocks so that the number of integration stages in each block falls within the range of the formula (1), and each block is provided with a bypass diode attached thereto in parallel and connected mutually in series, thereby achieving a thin-film solar cell module of high voltage output, while ensuring its hotspot resistance. This is because the bypass diode, being attached in parallel, works at the time of the occurrence of hotspot to almost short-circuit the output of the block, thereby preventing influence of the other blocks.

Furthermore, cell string dividing grooves 8 running in the vertical direction of FIG. 2(a) are formed in the cell string 10 produced in that way to divide the cell string 10 to a plurality of pieces in the transverse direction of FIG. 2, thereby forming unit cell strings 10a. Here, the division to the unit cell strings is performed to hold power generation per unit cell string 10a to a certain value or lower for improvement of the hotspot resistance. The smaller output Pa of the unit cell strings 10a is, the better, in terms of prevention of damages to the cells due to a hotspot phenomenon. The upper limit of the output Pa of the unit cell strings is obtained by a cell hotspot resistance test to be described later, which is 12 W. The output Pa of the unit cell strings can be calculated according to the following formula (4):

$$\text{Pa} = (\text{P} / \text{S}) \times \text{Sa} \qquad (4),$$

wherein
P is the output of the thin-film solar cell module;
S is the area of the effective power generation region of the thin-film solar cell module; and

Sa is the area of the unit cell strings 10a.

In order to lower output Ps of the unit cell strings 10a when output P of the thin-film solar cell module is constant, the number of unit cell strings 10a included in the thin-film solar cell module needs to be increased, that is, the number of string dividing grooves 8 needs to be increased. The more the number of parallel division stages is, the more advantageous, when considering only the upper limit of the output Ps of the unit cell strings 10a. However, when the number of parallel division stages is increased, power density applied to the contact lines (P - Ps) / Sc increases, and the contact lines 5c become likely to be damaged for the following reasons (1) to (3). Here, P is the output of the thin-film solar cell module, Ps is the output possible from the cell string in shade, and Sc is the area of the contact lines 5c.

(1) Increase of power applied from the other unit cell strings

When one unit cell string 10a is in shade, power generated in all the other cell strings is applied to the unit cell string 10a in shade. The value of the power applied to the unit cell string 10a in shade is (P - Ps). When the number of parallel divisions is increased to reduce the output Pa of the unit cell string 10a, the power to be applied to the unit cell string 10a in shade increases, because the smaller the value of the output Pa of the unit cell string 10a is, the larger the value of the (P - Ps) is.

(2) Decrease of contact line area

When the number of parallel divisions is increased, a length L of the contact lines 5c illustrated in FIG. 2(b) is shortened, and, as a result, an area Sc of the contact lines 5c is made smaller. As a result, the value of resistance of the contact lines 5c increases.

(3) Increase of applied power density in connection grooves

As described above, the value of the (P - Ps) increases, and the area Sc of the contact P lines is made smaller, when the number of parallel divisions is increased. Therefore, the power density (P - Ps) /Sc applied to the contact lines 5c increases, and the contact lines 5c become likely to be damaged.

In order to prevent damage of the contact lines 5c, it is necessary to hold the power density (P - Ps) / Sc applied to the contact lines 5c to the upper limit thereof or lower. The upper limit of the power density (P - Ps) / Sc applied to the contact lines 5c can be determined according to the reverse overcurrent resistance test to be described later, which was 10.7 $(kW/cm^2)$. The power density (P - Ps) / Sc applied to the contact lines is not limited in particular as long as it is 10.7 $(kW/cm^2)$ or less.

Here, a cell hotspot resistance test will be described.

At first, thin-film solar cell modules of the thin-film solar cell string 1 are produced and a reverse voltage of 5 V to 8 V is applied thereto, and the modules are measured for I-V and the current $cm^2$ (referred to as RB current) obtained when the reverse current is varied from 0.019 $mA/cm^2$ to 6.44 mA/. Out of the measured samples, samples having different reverse currents are divided in parallel so that the output of the string to be evaluated is 5 to 50 W. Then, a hotspot resistance test is performed on a thin-film solar cell element (one cell). The hotspot resistance test was in accordance with ICE 61646, 1st EDITION, and here the acceptance line was made severer by 10% in terms of an aim to make the appearance better. As for the peeled area, the area of a region where a film is peeled off was measured by photographing the sample surface from the substrate side of the thin-film solar cell module. Results of the measurement on the samples having different cell string outputs or RB currents have revealed that cases of moderate RB currents (0.31 to 2.06 $mA/cm^2$) are prone to peel-off of a film. It has been also revealed that the peeled area can be held to 5% or less regardless of the magnitude of the RB current, when the output of the cell string is 12 W or less. Thus, the output Ps of the unit cell string was set to 12 W or less.

Next, the reverse overcurrent resistance test will be described. At first, thin-film solar cell modules of the thin-film solar cell string 1 were produced, and the reverse overcurrent resistance test was performed by applying an overcurrent in a direction opposite to the direction of the power generation current and examining damage of the contact lines. According to the provisions of IEC 61730, the current to be applied here should be 1.35 times the anti-overcurrent specification value, and was set to 5.5 A at 70 V here.

When the above-specified voltage and current are applied to the thin-film solar cell module, the current is divided to be applied to the cell strings connected in parallel. However, the current is not divided equally, because the value of resistance varies from cell string to cell string. In the worst case, all the 5.5A at 70 V may be applied to one cell string. It is necessary to perform the test to see whether or not the cell string is damaged even in the worst case. Therefore, samples were produced with the width of the contact lines changed to 20 $\mu$m and 40 $\mu$m and the length of the contact lines changed to 8.2 mm to 37.5 cm to judge damage of the contact lines by visual inspection. As a result, it has been revealed that the area of the contact lines should be 20 $\mu$m $\times$ 18 cm or 40 $\mu$m $\times$ 9 cm = 0.036 $cm^2$ or more. The power applied to the cell strings is 385 W, which leads to 385 W ÷ 0.036 cm² = 10.7 (kW/cm²).

After the string dividing grooves 8 are formed as described above, the cell string 10 is divided into two, upper and lower, regions by using a metal electrode 7. Specifically, a current-collecting electrode 7a is attached to the upper end in FIG. 2 and a current-collecting electrode 7b is attached to the lower end in FIG. 2, and the unit cell strings divided by the dividing grooves 8 running in the vertical direction are connected in parallel again. At the same time, a current-collecting electrode 7c for taking a center line is added between the two current-collecting electrodes 7a and 7b, dividing as a border the unit cell strings 10a into two, upper and lower, regions. Thereby, this integrated substrate 1 is divided to 12 × 2 = 24 regions. The current-collecting electrode 7c for taking a center line may be attached directly onto the second electrode 7 of the cell string as illustrated in FIG. 2(b). Alternatively, a space for an electrode for taking a center line may be provided between the upper region and the lower region for the attachment of the current-collecting electrode 7c.

FIG. 3 illustrates a circuit diagram of the thin-film solar cell module as a whole. Unit cell strings having a plurality of thin-film solar cell elements connected in series are connected to bypass diodes in parallel. Specifically, bypass diodes 12 are prepared in a terminal box 11, and lead wires 14, 15, 16 led out of each unit cell string 10a are arranged there to connect two cell strings to two bypass diodes 12 in parallel. Since the two bypass diodes 12 are connected in series, a plurality of cell strings are connected in series in a direction in which the plurality of thin-film solar cell elements are connected in series. Thereby, the number of series connections in the unit string can be held to the number of stages specified in the formula (1) and, at the same time, a two-fold voltage can be outputted between terminals 13.

While each unit cell string is connected within the terminal box 11 in the above-described thin-film solar cell string 1, it may be connected onto a supporting substrate 1 of the thin-film solar cell module by providing and using a wire. In this case, the wire provided on the supporting substrate 1 may be formed at the same time as the formation of the current-collecting electrode 7, or a separate wire such as a jumper wire may be used.

When a three-junction type cell in which two amorphous silicon cells and one microcrystalline silicon cell are laminated is used for the photoelectric conversion layer in the configuration of this thin-film solar cell string 1, the calculation shown in the formula (1) will be as follows:

$$Rshm = 4000\ [\Omega]$$

$$Vpm = 1.80\ [V]$$

$$Ipm = 62\ [mA]$$

$$n < Rshm \div 2.5 \div Vpm \times Ipm +1 = 56.1$$

Therefore, since n needs to be 56 stages or less according to the formula (1), the thin-film solar cell string 1 is provided with the current-collecting electrode 7c for taking a center in the middle of its series structure of 106 stages, and each unit cell string 10a is of 53 stages.

In addition, while the thin-film solar cell string 1 has one current-collecting electrode 7c for taking a center, the number of lines for taking a center may be increased by increasing the number of divisions according to the number of integration stages of the substrate as a whole and individual cell voltage so that the number of integration stages per region is decreased. Furthermore, one block is acceptable when the output voltage is equal to or lower than the voltage to be obtained according to the number of stages of the formula (1).

<Thin-film solar cell string 2>

$$- 53\ stages \times 6\ parallels \times 4\ blocks\ in\ series -$$

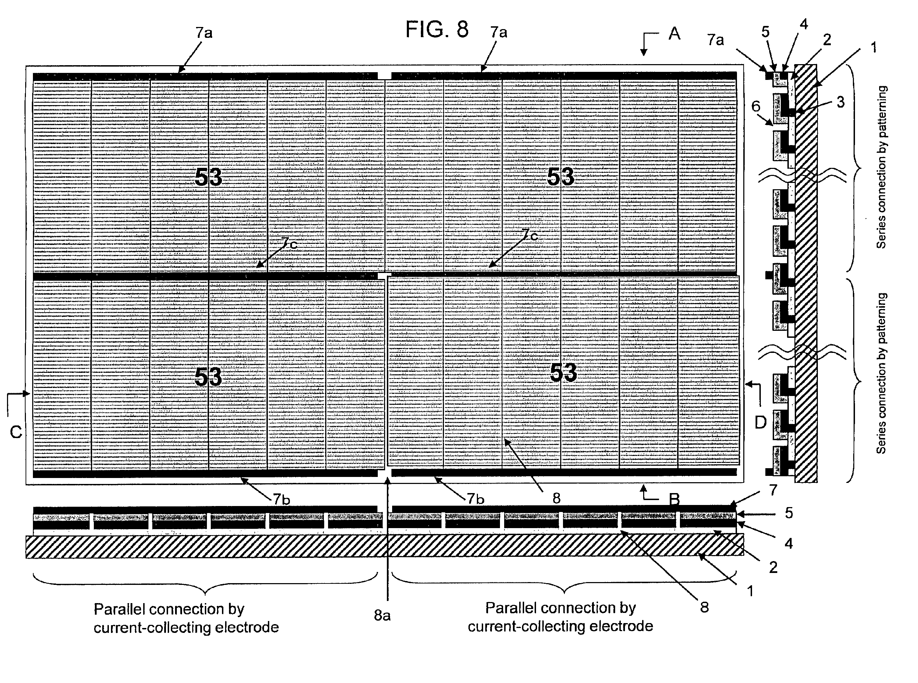

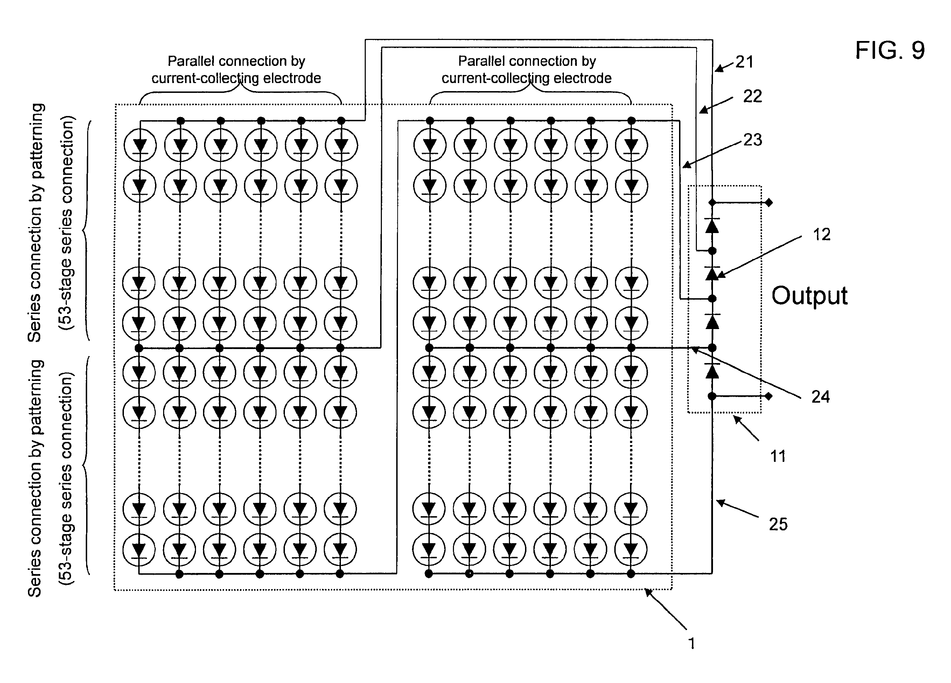

FIG. 8 illustrates an integrated thin-film solar cell module associated with the thin-film solar cell string 2, and FIG. 8(a) is a plan view, FIG. 8(b) is a cross-sectional view taken along lines E-F of FIG. 8(a), and FIG. 8(c) is a cross-sectional view taken along lines G-H of FIG. 8(a). FIG. 9 illustrates a circuit diagram.

The thin-film solar cell string 2 is characterized in a connection method after division in order to output a higher voltage. The other configurations and the production method are the same as those of the thin-film solar cell string 1. Specifically, processes up to the formation of the first electrode 2, the dividing scribe lines 3, the photoelectric conversion film 4, the second electrode 5, and the cell dividing grooves 6 are the same as those of the thin-film solar cell string 1. Successively, the cell string is divided to 12 unit cell strings by the cell string dividing grooves 8 running in the vertical direction. At the time of the division, a middle string dividing groove 8a is made wider. Since a high voltage equivalent to half of the thin-film solar cell module operation voltage is applied to this part during power generation, it is necessary to ensure a breakdown voltage. In the thin-film solar cell string 2, the string dividing groove 8a is approximately twice as wide as the other string dividing grooves 8. It is needless to say that the string dividing groove 8a may be filled with a resin, or an insulation film may be formed to increase a withstand voltage.

Thereafter, current-collecting electrodes 7a, 7b, 7c are formed separately so that each of them is divided into one for the cell string on the right in FIG. 8 and one for the cell string on the left in FIG. 8 to be independent electrodes. Thereby, four blocks of 53 stages of series connection × 6 parallels are completed. As shown in FIG. 9, wiring is made to the bypass diodes 12 within the terminal box 11 with the use of lead wires 21 to 25 to form a 4-block series connection. Thus, a thin-film solar cell module outputting a further voltage twice the voltage of the thin-film solar cell string 1 can be achieved. In other words, an output voltage that is 4 times that of the cell string is obtained. Therefore, a plurality of cell strings are connected in series in a direction in which a plurality of thin-film solar cell elements are connected in series, and a plurality of cell strings are connected in series in a direction perpendicular to the direction in which a plurality of thin-film solar cell elements are connected in series. Thereby, the number of series connections in a unit cell string can be held to the number of stages specified in the formula (1) and, at the same time, a four-fold voltage can be outputted between the terminals 13.

As for the wiring for the 4-block series connection, lead wires led from each block may be directly connected within the thin-film solar cell module, lead wires led from each block may be connected within the terminal box as illustrated in FIG. 9, or the wires may be connected in series after once being brought to outside of the module.

In addition, the bypass diodes 12 are attached to every series block in parallel as in the case of the thin-film solar cell string 1. Thereby, the number of series connections in one region can be held to the number of stages specified in the formula (1) or less and, at the same time, a four-fold voltage can be outputted. As for the bypass diodes 12, a small and thin type may be built in the thin-film solar cell module or may be built in the terminal box.

When the thin-film solar cell string is divided in a direction different from the integration direction of the solar cell elements, for example, in a direction perpendicular thereto, and the divided is reconnected as in the case of the thin-film solar cell string 2, a higher voltage can be achieved while keeping an optimal integration pitch, that is, a higher voltage can be achieved without losing module conversion efficiency, unlike the case in which the division is made only in the integration direction as in the case of the thin-film solar cell string 1.

<Thin-film solar cell string 3>

- Example of 48 stages × 5 parallels × 4 blocks in series achieved by using two substrates of 48 stages × 5 parallels x 2 blocks in series -

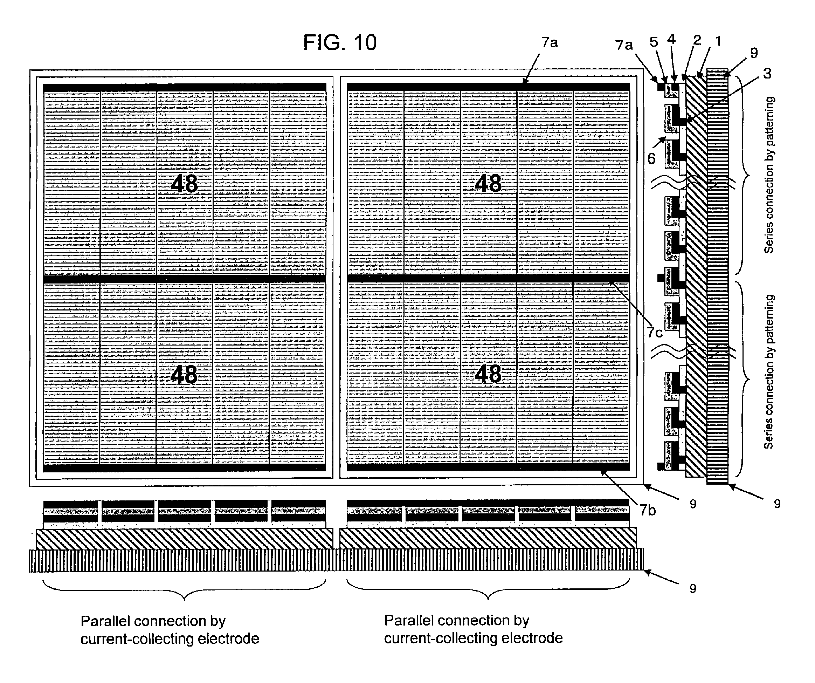

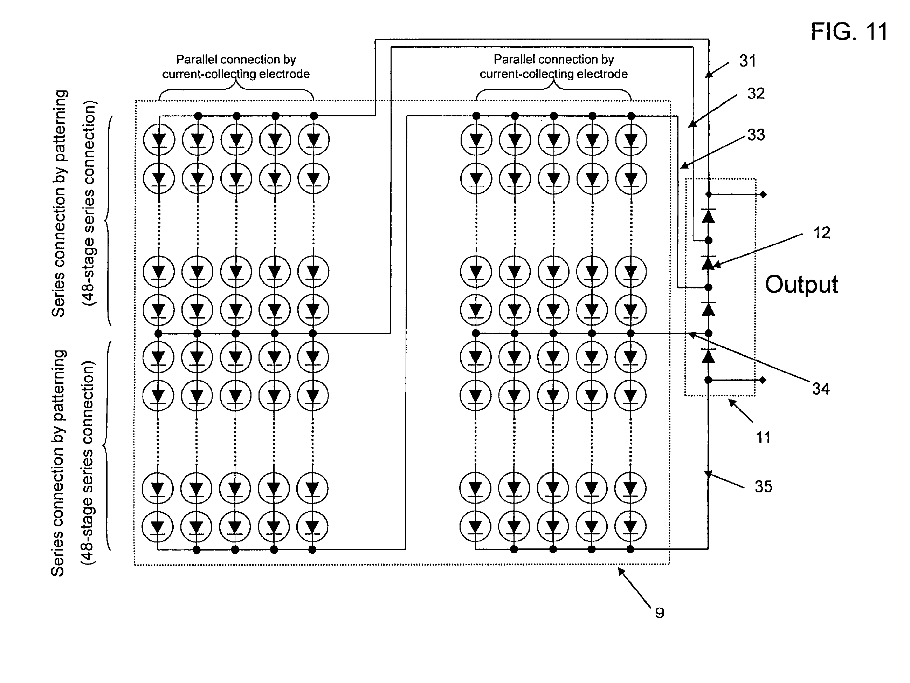

As for the thin-film solar cell strings 1 and 2, the supporting substrate itself is large, and have been described examples of the thin-film solar cell module in which all cell strings are formed on the substrate. However, even in the case where a plurality of small supporting substrates are combined to from a large solar cell module, similar problems will arise. In that case, a module of high voltage can be produced while ensuring reliability by forming cell strings in respective supporting substrates so that the requirement shown in the formula (1) is met and connecting the cell strings together. That is, the cell strings are formed in the same manner as in the thin-film solar cell strings 1 and 2, and arranged in two small sized integrated substrates connected in parallel on one integrated substrate 9 as illustrated in FIG. 10. That is, two supporting substrates 1 of the thin-film solar cell module are mounted on the integrated substrate 9 formed of one cover glass, and configured to be integrated together as illustrated in FIG. 10. And, they are connected in series in the terminal box 11 as illustrated in FIG. 11.

The above-described small supporting substrates may be sealed separately to be integrated on the integrated substrate as illustrated in FIG. 10, or may be integrated by using a frame. Or, the two small supporting substrates may be mounted on one integrated substrate and sealed to be integrated together as described above. Or, the two supporting substrates may be sealed separately and integrated with the use of a frame to form one thin-film solar cell module.

As for the thin-film solar cell strings 1 to 3 shown above, a thin-film solar cell module of a superstraight structure has been described; however, a thin-film solar cell module of a sub-straight structure is also applicable. In that case, the second electrode, the photoelectric conversion layer, and the first electrode are formed on the substrate in this order. In addition, while the above-described thin-film solar cell strings 1 to 3 are each provided with one terminal box, they may be each provided with a plurality of terminal boxes, and a plurality of terminal boxs may be wired to connect the cell strings in series.

Furthermore, as for the above-described thin-film solar cell strings 1 to 3, two cell strings are formed and divided into two; however, one cell string may be acceptable when the output voltage is satisfiable by the number of stages n of the cell strings. Moreover, the number of cell strings does not need to be an even number, and may be an odd number. In addition, as for the above-described thin-film solar cell strings 1 to 3, the cell strings are connected in series through the connection to the bypass diodes; however, the bypass diodes may be omitted to connect the cell strings directly, or the cell strings may be connected to a resistor or a load instead of the bypass diodes.

Embodiment 2

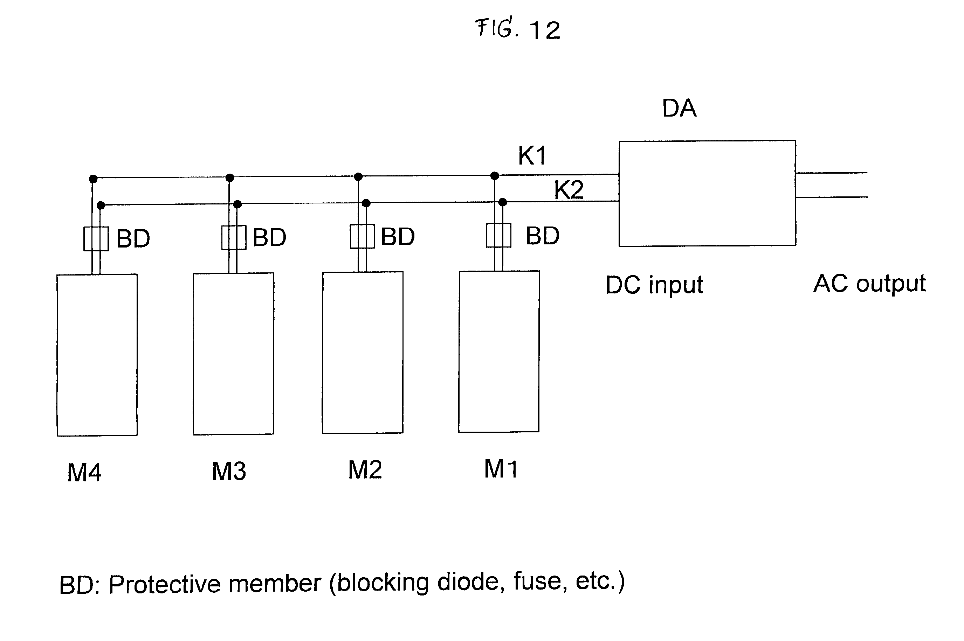

FIG. 12 illustrates a block diagram of a photovoltaic power system according to Embodiment 2. As illustrated in FIG. 12, thin-film solar cell modules M are **characterized in that** they are respectively provided with protective members BD inserted against connection lines K1, K2 connected to a DC/AC converter DA in parallel. The protective members BD are a blocking diode or a fuse. Other than that, a functional device may be used for protecting each thin-film solar cell module M from the other thin-film solar cell modules. The other configurations are the same as those of Embodiment 1. Thin-film solar cell strings 1 to 3 forming the thin-film solar cell modules are also the same as those of Embodiment 1.

Thus, each thin-film solar cell module M is independent and free from influence of the other thin-film solar cell modules M. That is, even if one solar cell module is in shade to decrease the output voltage, backflow to the solar cell module with the decreased output voltage is prevented.

Embodiment 3

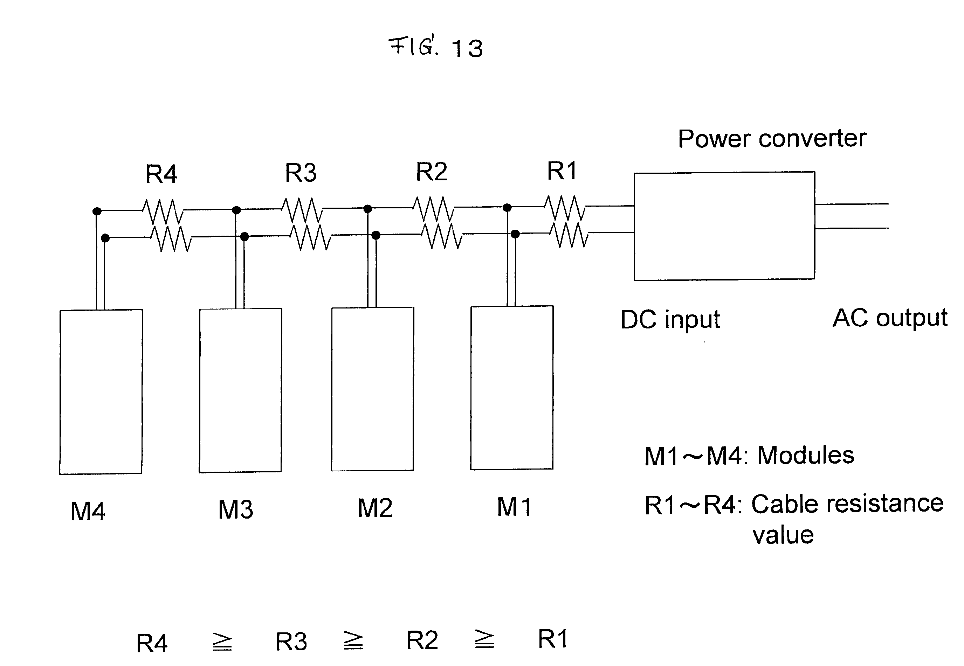

FIG. 13 illustrates a block diagram of a photovoltaic power system according to Embodiment 3. As illustrated in FIG. 13, resistances R1, R2, R3, R4 are respectively connected in connection lines K1, K2 that connect thin-film solar cell modules M in parallel. The closer the resistances R1, R2, R3, R4 are to a DC/AC converter DA, the smaller the value of resistance is. In addition, the resistances R1, R2, R3, R4 can be formed of the internal resistance of the connection lines K1 and K2. While the resistances R1, R2, R3, R4 of FIG. 13 are connected to the connection lines K1, K2, respectively, they may be connected to either of the connection lines K1 and K2. Furthermore, when the resistances R1, R2, R3, R4 are formed of the internal resistance of the connection lines K1 and K2, the size and the number of the connection lines K1 and K2 may be varied as needed. The resistances R1, R2, R3, R4 equalize the voltages at an input terminal of the DC/AC converter DA.

The other configurations are the same as those of Embodiment 1. Thin-film solar cell strings 1 to 3 forming the thin-film solar cell modules are also the same as those of Embodiment 1.

Embodiment 4

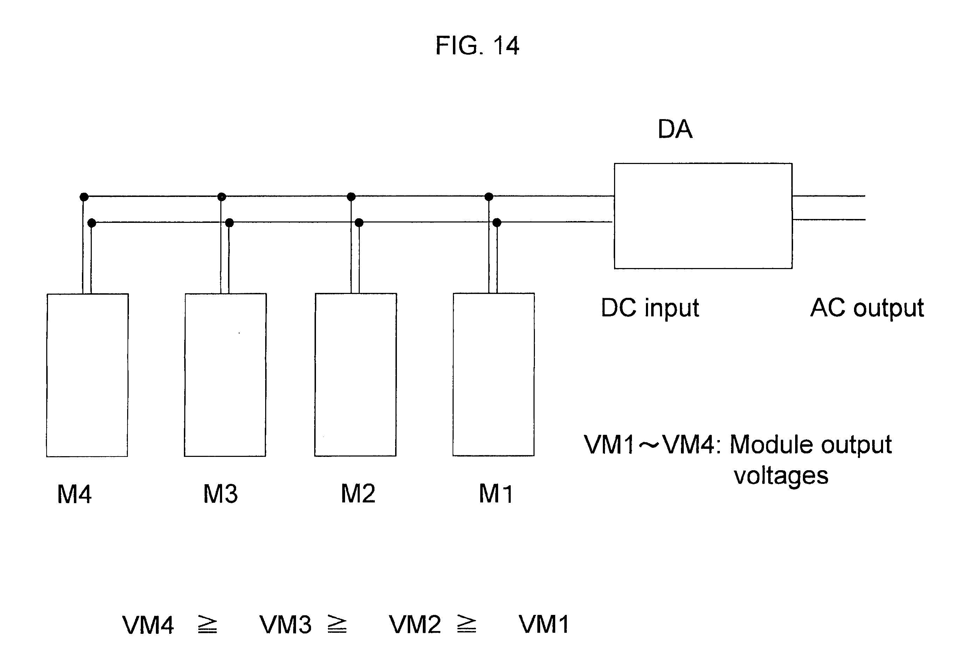

FIG. 14 illustrates a block diagram of a photovoltaic power system according to Embodiment 4. As illustrated in FIG. 14, the output voltages of a plurality of thin-film solar cell modules M are higher as they are further from a DC/AC converter DA and lower as they are closer to the DC/AC converter DA. And, the voltages are equalized at an input terminal of the DC/AC converter DA. When the plurality of thin-film solar cell modules M have uneven output voltages, they may be arranged in order of output voltage so that the thin-film solar cell module M having a lower output voltage is at the input terminal of the DC/AC converter DA.

The other configurations are the same as those of Embodiment 1. Thin-film solar cell strings 1 to 3 forming the thin-film solar cell modules are also the same as those of Embodiment 1.

As for Embodiments 1 to 4, examples have been described in which a DC/AC converting circuit is used as a power converter; however, the effects of the present invention are not limited to the DC/AC converting circuit. For example, the same effects can be obtained from a photovoltaic power system in which a DC/AC converting circuit is used for a power converting circuit.

**Claims**

1. A photovoltaic power system comprising:

    a plurality of solar cell modules connected in parallel to a power converter, the solar cell modules outputting a voltage higher than an output voltage of the power converter.

2. The photovoltaic power system according to Claim 1, wherein the output voltages of the solar cell modules are $\sqrt{2}$ to 10 times the output voltage of the power converter.

3. The photovoltaic power system according to Claim 1 or 2, wherein all the solar cell modules are connected in parallel.

4. The photovoltaic power system according to any one of Claims 1 to 3, linking with an AC commercial power system.

5. The photovoltaic power system according to any one of Claims 1 to 4, wherein the solar cell modules are thin-film solar cell modules comprising a thin-film solar cell string comprising a plurality of thin-film solar cell elements interconnected in series, each of the thin-film solar cell elements including a surface electrode, a photoelectric conversion layer, and a back surface electrode laminated in this order.

6. The photovoltaic power system according to Claim 1, wherein the thin-film solar cell modules each have a protective member inserted in a connection line for connection line connecting the thin-film solar cell modules to the power converter in parallel.

7. The photovoltaic power system according to Claim 6, wherein the protective member is a blocking diode or a fuse.

8. The photovoltaic power system according to Claim 1, wherein the thin-film solar cell modules each have a resistance connected in a connection line for connection line connecting the plurality of thin-film solar cell modules in parallel.

9. The photovoltaic power system according to Claim 8, wherein the closer the resistance is to the power converter, the smaller a value of the resistance is.

10. The photovoltaic power system according to Claim 8 or 9, wherein the resistance is formed of the connection line connecting the plurality of solar cell modules to the power converter in parallel.

11. The photovoltaic power system according to Claim 1, wherein the closer the plurality of solar cell modules are to the power converter, the lower the output voltage thereof is.

12. The photovoltaic power system according to Claim 5, wherein the thin-film solar cell string has a number of series connection stages of the thin-film solar cell elements that satisfies a following formula (1):

$$n < Rshm \: / \: 2.5 \: / \: Vpm \: \times \: Ipm + 1 \quad (1),$$

    wherein Rshm is a most frequent short-circuit resistance value of the thin-film solar cell elements;
    Vpm is an optimum operation voltage of the thin-film solar cell elements; and
    Ipm is an optimum operation current of the thin-film solar cell elements.

13. The photovoltaic power system according to Claim 12, wherein the optimum operation voltage of the thin-film solar cell string is more than 160 V.

FIG. 1

DA

Vdc

Vac

DC input          AC output

$Vdc > \alpha \times Vac$

$VM(n) > Vdc$

$A > \sqrt{2} + \beta$

M4          M3          M2          M1

VM(n):Module output voltage

Vdc:DC input voltage

Vac:AC output voltage
(effective value)

EP 2 249 394 A1

FIG. 2

(a)

53

53

(b)

Series connection by patterning

Series connection by patterning

(c) Parallel connection by current-collecting electrode

EP 2 249 394 A1

FIG. 3

FIG. 4(a)

$I_{t1} = I_{pm}$

$I_{ph} \uparrow$

$V_{t1} = V_{pm}$

FIG. 4(b)

$I_{t2}$

$I_{ph} \uparrow$

Mask

$V_{d1}$

$V_{t2}$

EP 2 249 394 A1

EP 2 249 394 A1

FIG. 5

Cell in light

$I1 = f(v) = Iph - Id - Irsh$

Iph ↑    Id    Vd    Irsh

Cell in shade

$I1 = f(v) = - Id - Irsh$

Id1    Vd1    Irsh

I-V of cell in light

It2

I-V of cell in shade
Slope=1/Rsh

Vd1

## FIG. 6

Rsh-Prsh property

Rsh    Rshpm

EP 2 249 394 A1

FIG. 7

EP 2 249 394 A1

# FIG. 8

Series connection by patterning

Series connection by patterning

Parallel connection by
current-collecting electrode

Parallel connection by
current-collecting electrode

FIG. 9

Parallel connection by current-collecting electrode

Parallel connection by current-collecting electrode

Series connection by patterning (53-stage series connection)

Series connection by patterning (53-stage series connection)

Output

21
22
23
12
24
11
25
1

EP 2 249 394 A1

FIG. 10

Series connection by patterning

Series connection by patterning

Parallel connection by
current-collecting electrode

Parallel connection by
current-collecting electrode

## FIG. 11

FIG. 12

DA

K1

K2

DC input

AC output

BD

BD

BD

BD

M4

M3

M2

M1

BD: Protective member (blocking diode, fuse, etc.)

EP 2 249 394 A1

# FIG. 13

Power converter

R4          R3          R2          R1

DC input                    AC output

M4          M3          M2          M1

M1～M4: Modules

R1～R4: Cable resistance
        value

R4    ≧    R3    ≧    R2    ≧    R1

EP 2 249 394 A1

## FIG. 14

DA

DC input          AC output

VM1~VM4: Module output
                voltages

M4          M3          M2          M1

VM4  $\geqq$  VM3  $\geqq$  VM2  $\geqq$  VM1

EP 2 249 394 A1

EP 2 249 394 A1

## INTERNATIONAL SEARCH REPORT

| International application No. |
|---|
| PCT/JP2009/053197 |

A. CLASSIFICATION OF SUBJECT MATTER
*H01L31/04(2006.01)i, H01L31/042(2006.01)i*

According to International Patent Classification (IPC) or to both national classification and IPC

B. FIELDS SEARCHED

Minimum documentation searched (classification system followed by classification symbols)
H01L31/04, H01L31/042

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho  1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | Masaki EGUCHI et al., "Jutakuyo Taiyoko Hatsuden System-yo String Power Conditioner", Sharp Technical Journal, 2002.08, No.83, pages 63 to 64 | 1-4,8-11<br>5-7,12-13 |
| Y | JP 2001-68713 A  (Kaneka Corp.), 16 March, 2001 (16.03.01), Par. Nos. [0043] to [0050] & US 6288323 B1        & EP 1079441 A3 & EP 1079441 A2 | 5,12-13 |
| Y | JP 8-185235 A  (Sharp Corp.), 16 July, 1996 (16.07.96), Fig. 1 (Family: none) | 6-7 |

☒ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 March, 2009 (11.03.09) | 24 March, 2009 (24.03.09) |

| Name and mailing address of the ISA/<br>Japanese Patent Office | Authorized officer |
|---|---|
| Facsimile No. | Telephone No. |

Form PCT/ISA/210 (second sheet) (April 2007)

28

**INTERNATIONAL SEARCH REPORT**

| International application No. |
|---|
| PCT/JP2009/053197 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-94660 A (Sharp Corp.), 25 March, 2004 (25.03.04), Par. No. [0005] (Family: none) | 1-13 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 20021246694 B